# EUROPÄISCHE PATENTSCHRIFT

(11) **EP 1 636 826 B1**
(45) Veröffentlichungstag und Bekanntmachung des Hinweises auf die Patenterteilung: **10.09.2008**
(21) Anmeldenummer: 04738767.5
(22) Anmeldetag: 18.06.2004
(51) Int. Cl.: H01L 21/00

(54) **VERBINDUNG ZUR BILDUNG EINER SELBSTORGANISIERENDEN MONOLAGE, SCHICHTSTRUKTUR, HALBLEITERBAUELEMENT MIT EINER SCHICHTSTRUKTUR UND VERFAHREN ZUR HERSTELLUNG EINER SCHICHTSTRUKTUR**
COMPOUND USED TO FORM A SELF-ASSEMBLED MONOLAYER, LAYER STRUCTURE, SEMICONDUCTOR COMPONENT HAVING A LAYER STRUCTURE, AND METHOD FOR PRODUCING A LAYER STRUCTURE
PROCEDE DE FORMATION D'UNE MONOCOUCHE AUTO-ORGANISEE, STRUCTURE DE COUCHES, COMPOSANT A SEMICONDUCTEURS COMPORTANT UNE STRUCTURE DE COUCHES ET PROCEDE DE FABRICATION D'UNE STRUCTURE DE COUCHES

(30) Priorität: 20.06.2003 DE 10328811
(43) Veröffentlichungstag der Anmeldung: 22.03.2006
(73) Patentinhaber: Qimonda AG, 81739 München (DE)
(72) Erfinder: SCHMID, Günter, 91334 Hemhofen (DE); HALIK, Marcus, 91058 Erlangen (DE); KLAUK, Hagen, 70295 Stuttgart (DE); ZSCHIESCHANG, Ute, 70195 Stuttgart (DE); EFFENBERGER, Franz, 70597 Stuttgart (DE); SCHÜTZ, Markus, 70565 Stuttgart (DE); MAISCH, Steffen, 70839 Gerlingen (DE); SEIFRITZ, Steffen, 45968 Gladbeck (DE); BUCKEL, Frank, 47800 Krefeld (DE)
(74) Vertreter: Gross, Felix
(86) Internationale Anmeldenummer: PCT/DE2004/001318
(87) Internationale Veröffentlichungsnummer: WO 2004/114371

(56) Entgegenhaltungen:
- EP-A- 1 179 863
- WO-A-02/086979
- WO-A-03/023517
- WO-A-03/077327
- DE-A- 19 815 220
- US-A1- 2001 055 768
- PATENT ABSTRACTS OF JAPAN Bd. 2003, Nr. 07, 3. Juli 2003 (2003-07-03) -& JP 2003 092411 A (LUCENT TECHNOL INC), 28. März 2003 (2003-03-28)
- GERSHEVITZ, OLGA ET AL: "Molecular Monolayer -Mediated Control over Semiconductor Surfaces: Evidence for Molecular Depolarization of Silane Monolayers on Si/SiOx" JOURNAL OF THE AMERICAN CHEMICAL SOCIETY , 125(16), 4730-4731 CODEN: JACSAT; ISSN: 0002-7863, 2003, XP002299959
- TILLMAN, NOLAN ET AL: "Incorporation of phenoxy groups in self-assembled monolayers of trichlorosilane derivatives: Effects on film thickness, wettability, and molecular orientation" JOURNAL OF THE AMERICAN CHEMICAL SOCIETY , 110(18), 6136-6144 CODEN: JACSAT; ISSN: 0002-7863, 1988, XP002299960
- TILLMAN, NOLAN ET AL: "A novel self-assembling monolayer film containing a sulfone-substituted aromatic group" LANGMUIR , 6(9), 1512-18 CODEN: LANGD5; ISSN: 0743-7463, 1990, XP002300327
- GERSHEWITZ, OLGA ET AL: "Effect of Molecule-Molecule Interaction on the Electronic Properties of Molecularly Modified Si/SiOx Surfaces" JOURNAL OF PHYSICAL CHEMISTRY B , 108(2), 664-672 CODEN: JPCBFK; ISSN: 1520-6106, 2004, XP002299962
- TURGEMAN, R. ET AL: "Oriented Growth of ZnO Crystals on Self-Assembled Monolayers of Functionalized Alkyl Silanes" CRYSTAL GROWTH & DESIGN , 4(1), 169-175 CODEN: CGDEFU; ISSN: 1528-7483, 2004, XP002299963

## Beschreibung

Die Erfindung betrifft ein Halbleiterbauelement nach Anspruch 17 und ein Verfahren zur Herstellung einer Schichtstruktur nach Anspruch 19.

Feldeffekttransistoren auf der Basis organischer Halbleiter (OFET) sind für eine Vielzahl elektronischer Anwendungen von Interesse. Insbesondere sind damit niedrige Fertigungskosten, flexible oder unzerbrechliche Substrate, oder die Herstellung von Transistoren und integrierten Schaltungen über große aktive Flächen möglich. Zum Beispiel eignen sich organische Feldeffekt-Transistoren als Pixel-Steuerelemente in Aktiv-Matrix-Bildschirmen oder für die Herstellung von extrem preiswerten integrierten Schaltungen, wie sie zum Beispiel für die aktive Kennzeichnung und Identifizierung von Waren und Gütern zum Einsatz kommen.

Da sich mit organischen Feldeffekttransistoren komplexe Schaltungen aufbauen lassen, bestehen zahlreiche Anwendungsmöglichkeiten. So gilt beispielsweise die Einführung von RF-ID (RF-ID: radio frequency identification) Systemen basierend auf dieser Technologie als potentieller Ersatz für den störanfällige- und nur in direktem Sichtkontakt zum Scanner anwendbaren Barcode. Passive RF-ID Systeme beziehen ihre Energie aus dem eingestrahlten Wechselfeld. Der mögliche Abstand zwischen Lesegerät und Transponder hängt dabei von der abgestrahlten Leistung und dem Energiebedarf des Transponders ab. Siliziumbasierte Transponder arbeiten deshalb bei Versorgungsspannungen um 3V. Produkte, die einen siliziumbasierten Chip enthalten, sind für viele Anwendungen zu teuer. Beispielsweise kommt für die Kennzeichnung von Lebensmitteln (Preis, Verfallsdatum etc.) ein siliziumbasiertes Ident-Tag nicht in Betracht.

Organische Feldeffekttransistoren bestehen normalerweise aus mindestens vier verschiedenen, übereinander aufgebrachten Schichten: einer Gateelektrode, einem Dielektrikum, einer Source-Drain-Kontaktschicht und einem organischen Halbleiter. Die Reihenfolge der Schichten kann dabei variieren. Damit die Funktionalität entsteht, müssen die einzelnen Lagen strukturiert werden, was relativ aufwändig ist.

Polymere bzw. organische Halbleiter bieten das Potential, dass billige Drucktechniken zu ihrer Strukturierung und Applikation eingesetzt werden können. Das Gatepotential zur Steuerung der organischen Feldeffekttransistoren kann umso kleiner gewählt werden, je dünner das Gatedielektrikum (d.h. eine dielektrische Schicht) hergestellt werden kann.

In der Polymerelektronik wird die Dicke des Gatedielektrikums im Allgemeinen dahingehend optimiert, dass die Lösung eines Polymers immer dünner ausgeschleudert bzw. aufgedruckt wird (top-down). Diese Verfahrensweise stößt jedoch an ihre Grenzen, wenn Schichtdicken kleiner als 50 nm erzielt werden sollen.

Es ist bekannt, Schichten für organische Feldeffekttransistoren mittels selbstorganisierenden Schichten aus molekularen Monolagen aufzubauen (SAM: Self-Assembled Monolayers).

In den Artikeln von J. Collet, D. Vuillaume; "Nano-field effect transistor with an organic self-assembled monolayer as gate insulator", Applied Physics Letters 73 (1998) 2681; J. Collet, S. Lenfant, D. Vuillaume, O. Bouloussa, F. Rondelez, J. M. Gay, K. Kham, C. Chevrot; "High anisotropic conductivity in organic insulator / semiconductor monolayer heterostructure", Applied Physic Letters 76 (2000) 1339 und J. Collet, O. Tharaud, A. Chapoton, D. Vuillaume; "Lowvoltage, 30 nm channel length, organic transistors with a self-assembled monolayer as gate insulating films", Applied Physics Letters 76 (2000) 1941 werden solche Schichten beschrieben.

Auch in den Artikeln von Pradyt Ghosh, Richard M. Crooks; "Covalent Grafting of a Pattered, Hyperbranched Polymer onto Plastic Substrate Using Microcontact Printing", J. Am. Chem. Soc. 121 (1999) 8395 -8306; William M. Lackowski, Pradyut Ghosh, Richard M. Crooks; "Micron-Scale Patterning of Hyperbranched Polymer Films by Micro- Contact Printing;", J. Am. Chem. Soc. 121 (1999) 1419-1420 und Jacob Sagiv; "Process tor the production of built-up films by the stepwise adsorption of individual monolayers", US 4,539,061 (1985) wird auf diese Schichten eingegangen.

In den Artikeln von Collet et al. werden Materialien beschrieben, mit denen sich Transistoren mit SAM-Schichten aufbauen lassen. Dabei bilden Vinyl-terminierte Silane als Ankergruppen auf hydroxylhaltigen Substratflächen eine SAM aus. Anschließend wird diese SAM chemisch nachbehandelt, um weitere Moleküle chemisch an die SAM zu binden (siehe Artikel von Sagiv et al.) oder es werden Oberflächen hergestellt, die eine weitere Prozessierung zulassen (siehe Artikel von Collet, Tharaud et al.).

Dabei ist es nachteilig, dass diese Schichten nicht ohne Nachbehandlung eine dichte Dielektrikumsschicht bilden. Die eingesetzten chemischen Nachbehandlungen setzt bei einer Reaktionszeit von 48 bis 120 Stunden nur 70 bis 90% der Endgruppen um. Diese chemische Nachbehandlung dauert für die Fertigung hoher Stückzahlen zu lange.

Prinzipiell ist es auch möglich, Polymere über mehrere Koordinationsstellen an eine Oberfläche zu binden (Self-Assembled Polymers). Dies ist aus der US-A 5,728,431, US-A 5,783,648 (1998) und der US-A 5,686,549 bekannt.

Der vorliegenden Erfindung liegt die Aufgabe zugrunde, Mittel und Verfahren zur effizienten Herstellung eines Halbleiterbauelementes, insbesondere eines organischen Feldeffekttransistors zu schaffen.

Diese Aufgabe wird erfindungsgemäß durch die Verbindung, ω-Phenoxyoctadecyltrichlorsilan gelöst.

Durch eine molekulare Gruppe mit der Fähigkeit einer π-π Wechselwirkung mit anderen Verbindungen der gleichen Art und / oder Verbindungen anderer Art kann eine Stabilisierung einer molekularen Monolage erreicht werden. Die π-π Wechselwirkung erlaubt die wechselseitige Bindung der einzelnen Moleküle in der Monolage untereinander.

Dabei ist es vorteilhaft, wenn die molekulare Gruppe mit der Fähigkeit einer n-n Wechselwirkung ein Aromat oder ein kondensiertes Aromat mit bis zu fünf Ringsystemen aufweist, insbesondere ein Naphtalen, Anthracen, Naphtacen, Pentacen, Biphenyl, Terphenyl, Quaterphenyl und / oder Quinquephenyl. Auch ist es vorteilahft, wenn die molekulare Gruppe mit der Fähigkeit einer π-π Wechselwirkung mindestens eine der folgenden Gruppen aufweist:

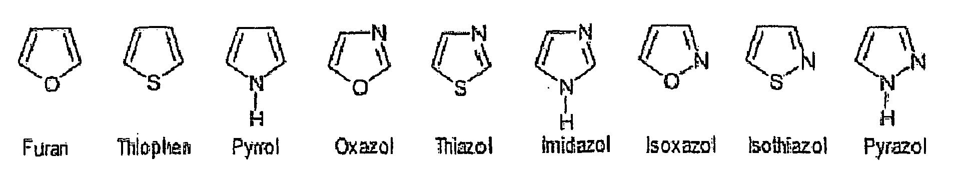

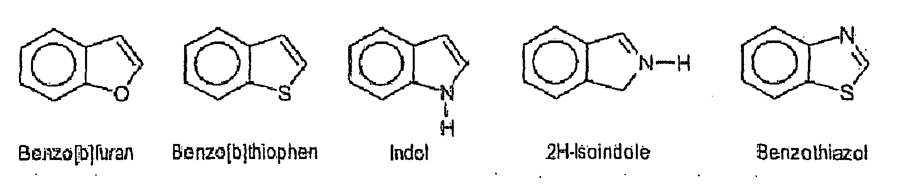

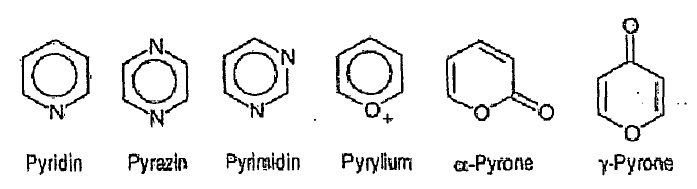

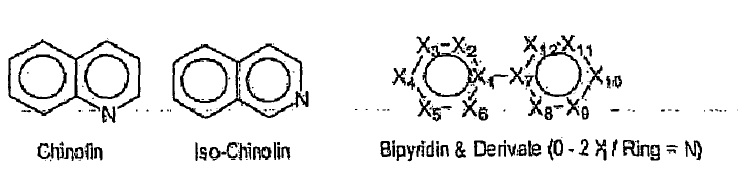

Mit Vorteil weist die Verbindung mindestens eine Ankergruppe zur Bindung an ein Substrat auf. Besonders vorteilhaft ist es, wenn eine Ankergruppe mindestens ein Silan, insbesondere ein Trichlorosilan, Dichlorosilan, ein Monochlorosilan, ein Trialkoxysilan, ein Dialkoxysilan und / oder ein Monoalkoxysilan aufweist.

Eine bevorzugte Ausführungsform des erfindungsgemäßen Moleküls ist im Wesentlichen linear aufgebaut ist und die molekulare Gruppe mit der Fähigkeit einer n-n Wechselwirkung ist als Kopfgruppe am von der Ankergruppe entfernten Ende der Verbindung angeordnet. Damit lassen sich Monolagen mit besonders stabiler Oberfläche erzeugen, so dass diese durch Verfahrensschritte strukturierbar ist.

Vorteilhafterweise ist die Verbindung als ein ω-substituiertes Alkylchlorsilan, Alkoxysilane, ein ω-substituiertes Alkanthiol und / oder -selenol, insbesondere Phenoxyoctadecanthiol, sowie ein analoges Disulfid und Selenid ausgebildet. Es ist auch vorteilhaft, wenn die Verbindung als ω-Phenoxy-octadeclytrichlorsilan, ω-Biphenyloxyoctadeclytrichlorsilan und / oder ein Thienyloctadeclytrichlorsilan ausgebildet ist.

Wenn die erfindungsgemäße Verbindung eine dielektrische Gruppe, insbesondere zur Bildung einer dielektrischen Schicht in einer Monolage aufweist, so kann diese bei der Herstellung von Halbleiterbauelementen (z.B. einem OFET) verwendet werden. Dabei ist es vorteilhaft, wenn dielektrische Gruppe mindestens eine n-Alkylgruppe mit n = 2 bis 20 aufweist. Alkylgruppen weisen gute dielektrische Eigenschaften auf.

Die Aufgabe wird durch ein Bauelement mit einer Schichtstruktur lt. Anspruch 1 gelöst.

Dabei ist es vorteilhaft, wenn die Monolage auf ein Substrat mit einer metallischen Oberfläche, einer metalloxidischen Oberfläche und / oder einer Kunststoffoberfläche angeordnet ist. Besonders vorteilhaft ist es, wenn ein Substrat eine hydroxylgruppenhaltigen Oberfläche, insbesondere ein Substrat aus Silizium, Titan oder Aluminium, aufweist. An diese Oberflächen binden sich Ankergruppen in effizienter Weise.

Eine vorteilhafte Ausführungsform der erfindungsgemäßen Schichtstruktur weist folgende Schichten auf:
a) die Monolage mit Ankergruppen, die mit dem Substrat verbunden ist,
b) vom Substrat aus gesehen oberhalb der Ankergruppen eine Schicht aus dielektrischen Gruppen
c) oberhalb der dielektrischen Gruppen eine Schicht aus molekularen Gruppen mit der Fähigkeit einer π-π Wechselwirkung.

Zur Ausbildung einer gleichmäßigen Schichtenstruktur ist es vorteilhaft, wenn die Ankergruppe, die dielektrische Gruppe und die molekulare Gruppe mit einer Fähigkeit der π-π Wechselwirkung im wesentlichen die gleichen Längen aufweisen.

Ferner ist es vorteilhaft, wenn auf eine Monolage mindestens eine weitere Schicht, insbesondere eine Metallschicht angeordnet ist.

Die Aufgabe wird auch durch ein Halbleiterbauelement mit einer Schichtstruktur nach mindestens einem der Ansprüche 11 bis 16 gelöst. Dabei ist es besonders vorteilhaft, wenn das Halbleiterbauelement als organischer Feldeffekttransistor aufgebaut ist und eine Monolage mit mindestens einer dielektrischen Schicht aufweist.

Die Aufgabe wird auch durch ein Verfahren zur Herstellung einer Schichtstruktur nach mindestens einem der Ansprüche 11 bis 17 gelöst, in dem eine Monolage aus Verbindungen nach mindestens einem der Ansprüche 1 bis 10 aus einer flüssiger Phase oder einer Gasphase auf ein Substrat abgeschieden wird. Bei einem Abscheiden aus der Gasphase (verminderter Druck, erhöhte Temperatur) ergeben sich besonders hohe Dichten in den Schichten, was vorteilhaft ist.

Besonders vorteilhaft ist es, wenn eine Monolage aus Verbindungen nach mindestens einem der Ansprüche 1 bis 10 aus einer flüssigen Phase mit einem organischen Lösungsmittel in einem Tauchprozess abgeschieden wird.

Die Erfindung wird nachfolgend unter Bezugnahme auf die Figuren der Zeichnungen an mehreren Ausführungsbeispielen näher erläutert. Es zeigen:
- Fig. 1: die Strukturformel der Ausführungsform der erfindungsgemäßen Verbindung;
- Fig. 2: eine Monolage zur Bildung einer Schichtstruktur mit einer Ausführungsform der erfindungsgemäßen Verbindung auf einem Substrat;
- Fig. 3: Kopfgruppen mit der Fähigkeit einer π-π Wechselwirkung;
- Fig. 4: schematischer Aufbau eines organischen Feldeffekttransistors;
- Fig. 5A-C: drei Varianten einer Schichtstruktur für einen organischen Feldeffekttransistor;
- Fig. 6A-C: Kennlinien eines Transistors ohne eine erfindungsgemäße Schichtstruktur mit Siliziumgateelektrode;
- Fig. 7A-B: Kennlinien eines Transistors ohne eine erfindungsgemäße Schichtstruktur mit Aluminiumgatelektrode;
- Fig. 8A-C: Kennlinien eines Transistors mit einer ersten Ausführungsform einer erfindungsgemäßen Schichtstruktur (Top-Kontakt Architektur);
- Fig. 9A-C: Kennlinien eines Transistors mit einer zweiten Ausführungsform einer erfindungsgemäßen Schichtstruktur (Bottom-Kontakt Architektur);
- Fig. 10A, B: Kennlinien eines Transistors mit einer dritten Ausführungsform einer erfindungsgemäßen Schichtstruktur (Abscheidung aus der Gasphase) ;
- Fig. 11A, B: Kennlinien eines Transistors mit einer vierten Ausführungsform einer erfindungsgemäßen Schichtstruktur (Abscheidung aus der Gasphase) ;
- Tab. 1: Technologieparametervergleich zwischen organischen Feldeffekttransistoren mit erfindungsgemäßer Schichtstruktur und den Daten des 170 nm Knotens der Si-Technologie;
- Tab. 2: tabellarische Zusammenstellung der Versuchsergebnisse (Fig. 5 bis 9).

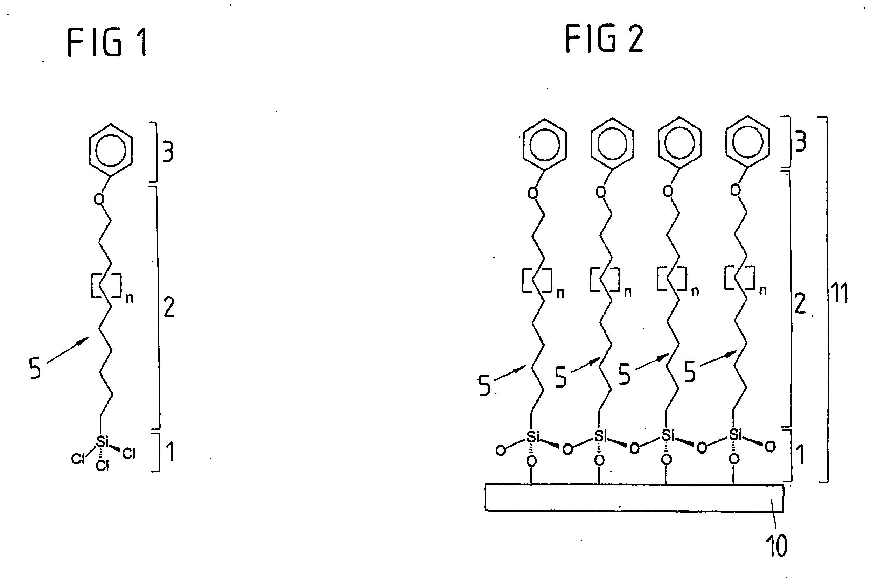

In Fig. 1 ist eine Strukturformel für eine Ausführungsform einer erfindungsgemäßen Verbindung 5 dargestellt. Die Verbindung 5 ist im Wesentlichen linear aufgebaut. An einem Ende ist eine Ankergruppe 1 angeordnet, die hier als Trichlorsilan ausgebildet ist. Diese Ankergruppe 1 erlaubt eine Bindung an ein hier nicht dargestelltes Substrat 10 (siehe Fig. 2). Oberhalb der Ankergruppe 1 ist eine dielektrische Gruppe 2 angeordnet, die als n-Alkyl ausgebildet ist. Die Kettenlänge beträgt n=2 bis 20. Am der Ankergruppe 1 entgegengesetzten Ende der Verbindung 5 ist eine Kopfgruppe 3 mit einem aromatischen System angeordnet. Diese Kopfgruppe 3 erlaubt eine n-n Wechselwirkung mit anderen Verbindungen der gleichen Art und / oder Verbindungen anderer Art zur Stabilisierung der Monolage (11).

Dies ist in Fig. 2 dargestellt, wobei hier Verbindungen gleicher Art eine Monolage 11 bilden, die eine Schichtenstruktur aufweist. Die Ankergruppen 1 der Moleküle sind hier an eine hydroxylhaltige Schicht eines Substrates 10 gebunden. Zwischen den Kopfgruppen 3 können π-π Wechselwirkung stattfinden, so dass sich eine äußerst stabile Schichtenstruktur ausbildet.

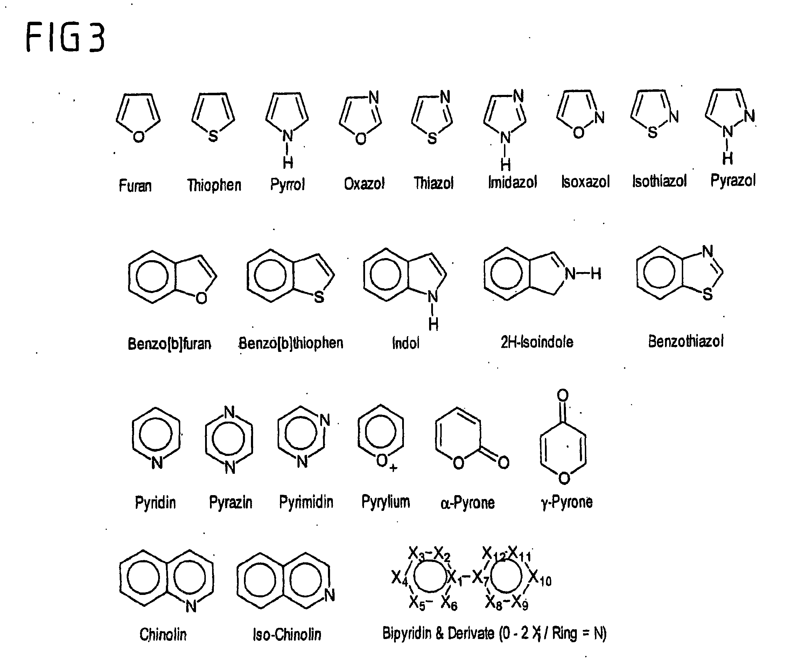

In Fig. 3 sind alternative Gruppen mit einer Fähigkeit einer π-π Wechselwirkung dargestellt. Es können auch andere aromatische Verbindung, insbesondere ein Naphtalen, Anthracen, Naphtacen, Pentacen, Biphenyl, Terphenyl, Quaterphenyl und / oder ein Quinquephenyl verwendet werden.

Auch sind Ketten mit jeweils unterschiedlichen aromatischen Ringsystemen in der Kette möglich. Über die Länge der kondensierten Ketten lassen sich die Eigenschaften gut einstellen. Dabei sind kleinere, meist nicht hochkondensierte Aromaten, die die im Wesentlichen einkristalline bzw. epitaktische zweidimensionale Struktur der Monolage 11 nicht stören, besonders gut geeignet.

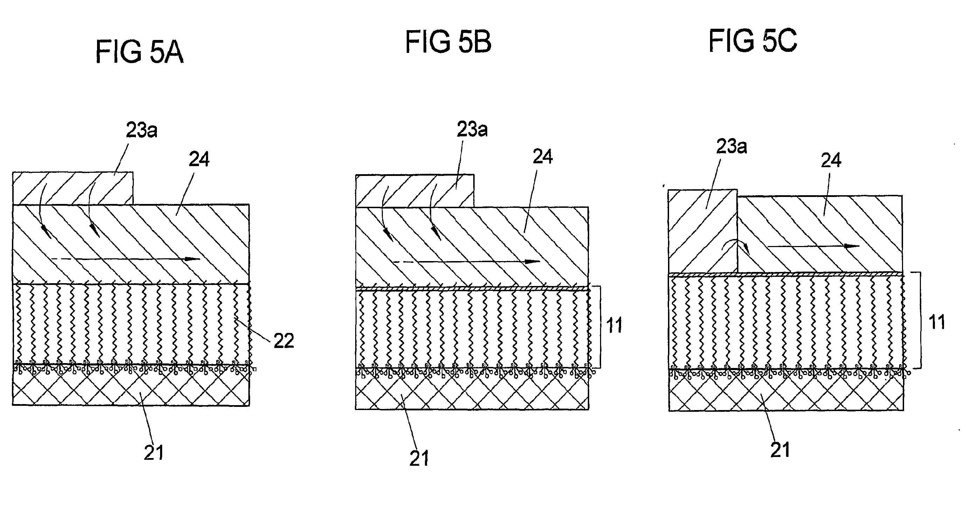

Mittels dieser Wechselwirkungen können Schichten ausgebildet werden, die für Dielektrika in organischen Feldeffekttransistoren gut geeignet sind. Im direkten Vergleich (siehe Fig. 5 bis 9) konnte gezeigt werden, dass SAMs ohne diese Kopfgruppe 3 ein sehr geringes Prozessfenster aufweisen bzw. die Materialkompatibilität zu Folgeschichten nicht gewährleistet ist. Im Folgenden werden SAMs mit Kopfgruppen, die zu π-π Wechselwirkungen befähigt sind, auch als T-SAMs bezeichnet.

Die π-π Wechselwirkung tritt bei den Monolagen 11 spontan ein und braucht nicht initiiert zu werden. Prinzipiell ist es möglich, auch innerhalb der SAM solche Gruppen zur Ausbildung einer π-π Wechselwirkung einzuführen, die dann allerdings nicht mehr als Kopfgruppen zu bezeichnen sind.

Die Leckströme derartiger T-SAMs sind so gering, dass sie als Dielektrika für organische Feldeffekttransistoren Verwendung finden können. Durch Ihre Dicke von nur ca. 3 nm sinkt die für den Betrieb dieser Transistoren nötige Versorgungsspannung auf 1 -2 V ab. Wenn aromatische Natur der Kopfgruppen ist auch für die chemische Inertheit der Monolagen 11 verantwortlich.

Im Folgenden werden die Vorteile dieser Monolagen 11 (T-SAM) näher erläutert.

Chemische Stabilität: Die T-SAM ist inert gegenüber allen Reagenzien, die nicht die Anbindung an die Substratoberfläche zerstören. Gegenüber aggressiven Reagenzien sind die T-SAMs eine gewisse Zeit beständig, da die Reagenzien erst durch die Monolage 11 diffundieren bzw. diese seitlich angreifen müssen. Diese Robustheit wurde bisher an keiner anderen SAM-Klasse beobachtet.

Prozessstabilität: Die T-SAMs tolerieren lithografische Schritte, wie das Aufbringen von Photolack, eine Photostrukturierung, Nassentwicklung und das Strippen von Photolack. Damit ist es möglich, z.B. auf dielektrischen Schichten weitere Schichten zur Bildung eines organischen Feldeffekttransistors aufzubauen.

Zeitliche Stabilität und Lagerstabilität: Zwischen der Abscheidung und weiterer Prozessierung können mehrere Wochen liegen, ohne dass es zu einem Abbau der T-SAM kommt; die Monolagen 11 sind haltbar.

Metallabscheidung: Auf die T-SAMs können flächenhaft in nahezu 100 % Ausbeute elektrochemisch oder über die Gasphase Metalle abgeschieden werden, ohne dass Kurzschlüsse auftreten. Diese hohe dielektrische "Qualität" wurde bisher bei keiner anderen SAM-Klasse beobachtet. So können auf einer SAM abgeschieden durch Octadecyltrichlorsilan (OTS) keine Metalle kurzschlussfrei aufgedampft werden, während ω-Phenoxy-octadecyltrichlorsilan derart dicke T-SAM Schichten bildet, dass bei Raumtemperaturen Metall auf große Flächen aufgedampft und strukturiert werden können.

Temperaturstabilität: Die T-SAMs sind bis Temperaturen oberhalb 200°C stabil.

Schichtdickenhomogenität: Die erhaltene Schichtdicke ist eine intrinsische Funktion der Molekülgeometrie und der Verankerung am Substrat. Schichtdickenschwankungen treten praktisch nicht auf.

Versorgungsspannung der Transistoren: Eine Dielektrikumsdicke von ca. 3 nm senkt die für den Betrieb notwendige Versorgungsspannung auf 1 -2 V ab. Ein direkter Vergleich zwischen dem 170 nm ITRS Knoten der Siliziumtechnologie und der Polymerelektronik bei gleicher Dielektrikumsdicke ist in Tabelle 1 zusammengefasst. Die Technologiedaten sind für ein Schaltungsdesign ausreichend.

Flexibilität in der Substratwahl: Die Verbindungen 5 eignen sich besonders für die Abscheidung auf hydroxylgruppenhaltigen Oberflächen, wie sie z. B. Silizium oder Aluminium an Luft natürlicherweise ausbilden. Geeignet sind aber auch Kunststoffoberflächen, die z.B. durch Plasmaschritte oder Ätzverfahren aktiviert wurden. Silane bilden dabei Si-O-Bindungen zur Oberfläche des Substrates 10 aus. Als Silane eignen sich insbesondere Tri-, Di, oder Monochlorosilane und Tri-, Di, oder Monoalkoxysilane.

Besonders bevorzugt ist als Verbindungen ω-Phenoxyoctadecyltrichlorosilan.

Verallgemeinert können zu T-SAMs befähigte Verbindungen auch mittels der SH-Kopplung an Gold oder Kupfer, mittels NC-Kopplung an Palladium oder mittels Aldehyd-Gruppe an wasserstoffterminiertes Silizium gebunden werden.

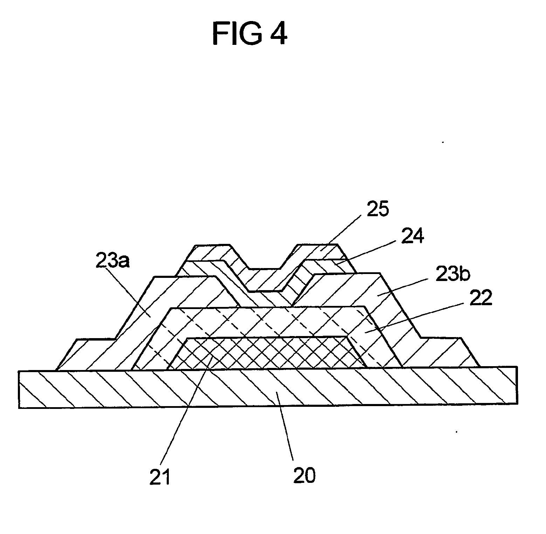

Bevor auf Ausführungsbeispiele zu den erfindungsgemäßen Schichtstrukturen mit Monolagen 11 eingegangen wird, soll anhand der Fig. 4 der Aufbau eines organischen Feldeffekttransistors erläutert werden.

Organische Feldeffekttransistoren sind elektronische Bauteile, die aus mehreren Schichten (Lagen) bestehen, welche alle strukturiert sind, um durch Verbindungen einzelner Schichten integrierte Schaltungen zu generieren. Dabei zeigt Fig. 5 den prinzipiellen Aufbau eines solchen Transistors in einer Bottom-Kontakt Architektur.

Auf einem Basis-Substrat 20 ist eine Gateelektrode 21 angeordnet, die von einer Gatedielektrikumsschicht 22 überdeckt ist. Eine solche Gatedielektrikumssicht 22 kann z.B. aus einer oben beschriebenen Monolage 11 bestehen. Derartige Dielektrika besitzen eine Schichtdicke von weniger als 5 nm (Bottom up).

Auf der Gatedielektrikumsschicht 22 sind eine Sourceschicht 23a und eine Drainschicht 23b angeordnet, die beide mit einer darbüberliegenden aktiven halbleitenden Schicht 24 in Verbindung stehen. Über der aktiven Schicht 24 ist eine Passivierungsschicht 25 angeordnet.

Im Folgenden werden Beispiele beschrieben, die die Funktion von Ausführungsformen der Erfindung beschreiben.

Dazu wurden zur Evaluierung der erfindungsgemäßen Monolagen 11 (T-SAMs) organische Feldeffekttransistoren in der sogenannten Top-Kontakt (Fig. 5a und 5b) bzw. Bottom-Kontakt Architektur hergestellt (Fig. 5c).

Bei der Top-Kontakt Architektur befinden sich die Source- und Drain Elektroden (23a, 23b) oberhalb, bei der Bottom-Kontakt Architektur in gleicher Ebene mit dem organischen Halbleiter 25. Dazu wurden bekannte Monolagen (SAM) und Monolagen gemäß der Erfindung (T-SAM) auf einem Gateelektrodenmaterial 21 als Substrat abgeschieden.

In den Fig. 5a bis 5c sind diese Versuchsvarianten schematisch dargestellt. Aus Gründen der Einfachheit wurde der Drain-Kontakt in den Fig. 5a bis 5c weggelassen.

Fig. 5a zeigt dabei eine bekannte Monolage (SAM) aus dielektrischem Material 22, die in einer Top-Kontakt Architektur verwendet wird. Die Monolage (SAM), die halbleitende Schicht 24 und der Source-Kontakt 23a wurden durch thermisches Aufdampfen aufgebracht.
Fig. 5b zeigt den gleichen Aufbau wie Fig. 5a, nur wird hier eine Ausführungsform der erfindungsgemäßen Schichtstruktur mit einer Monolage 11 auf dem Gatelelektrodenmaterial 21 angeordnet.

Fig. 5c zeigt eine Ausführungsform, bei der eine Ausführungsform der erfindungsgemäßen Schichtstruktur mit einer Monolage 11 verwendet wird. Allerdings ist hier der Source-Kontakt 23a in einer Bottom-Kontakt Architektur ausgebildet.

Im Folgenden wird auf die Messergebnisse eingegangen, wobei die Zahlenwerte der Versuche in Tab. 2 zusammengefasst sind.

### Beispiel 1 (SAM)

Auf einem hochdotierten Wafer als Gateelektrodenmaterial 21 wurde aus der Gasphase eine SAM aus Octadecyltrichlorosilan (OTS) abgeschieden. Anschließend wurden jeweils 30 nm organische Halbleiterschichten 24 aus
a. Pentazen oder
b. α,ω-Bisdecylsexithienyl
aus der Gasphase abgeschieden. Auf die Schicht 24 des organischen Halbleiters wurden 30 nm Gold über eine Schattenmaske als Source- und Drain Elektroden (23a, 23b) abgeschieden.

### Ergebnis:

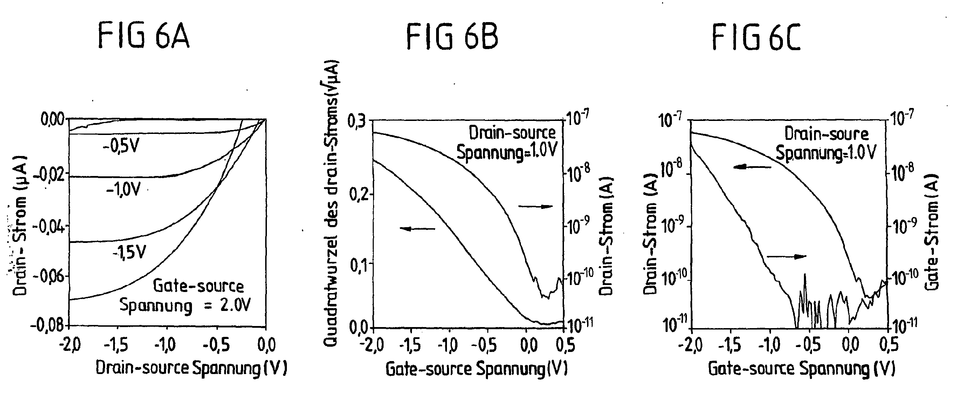

a. Im Falle von Pentazen wurden keine organischen Feldeffekttransistoren erhalten (Tabelle 2, Versuch UZ-36).
b. Im Falle von α,ω-Bisdecylsexithienyl (Tabelle 2, Versuch ZU-35) konnten Feldeffekttransistoren erhalten werden. Dies ist zurückzuführen auf die spezielle Alkyl-Alkyl-Wechselwirkung des Sexithiophens und der SAM. Die erhaltenen Kennlinien sind in Fig. 6a bis 6c dargestellt.
Transistor Charakteristik :
L = 130 µm
W = 170 µm
t_{SAM} = 2, 5 nm
ε_{SAM} = 2,5
µ= 0,04 cm²/Vs (Carrier mobility)
Threshold voltage = 0 V
Subthreshold slope = 200 mV / decade
on / off current ratio = 10³
drain / gate current ratio = 1.6.

Das Vorhandensein eines Feldeffekttransistorverhaltens hängt bei den SAM offenbar vom gewählten organischen Halbleitermaterial ab.

Kontrollexperimente zeigen, dass nur im Falle einer abgeschiedenen SAM eine Transistorfunktionalität erhalten wird. Eine native Oxidschicht auf Silizium ist dabei nicht ausreichend (Tabelle 2, Versuch UZ-37).

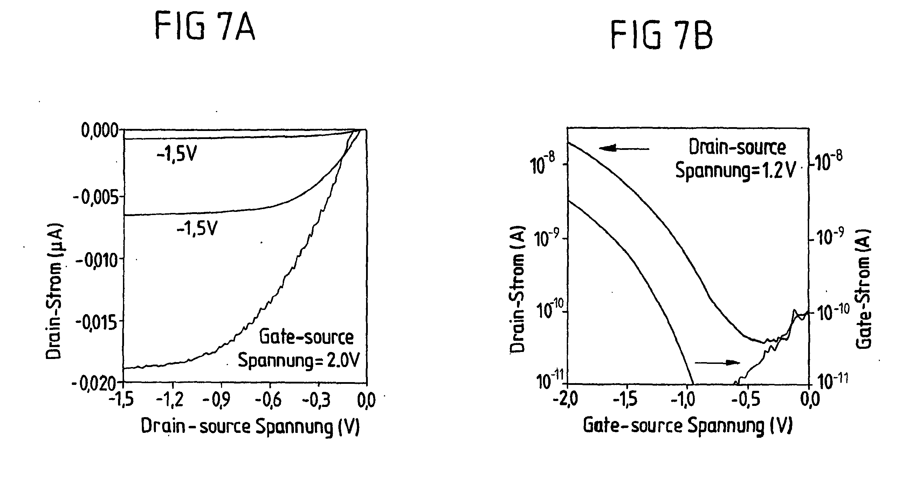

Alternativ zu Silizium als Substrat 11 bildet sich die OTS-SAM auch auf Aluminium aus. Die Kennlinien sind in Fig. 7 a und 7b dargestellt (Tabelle 2, Versuch ZU-43). Die Schichtdicke der OTS-SAM beträgt 2,5 nm. Die übrigen Parameter sind:
L = 130 µm
W = 170 µm
µ= 0,03 cm²/Vs (Carrier mobility)
Threshold voltage = -0,9 V
Subthreshold slope = 360 mV / decade
on / off current ratio = 10³

Für eine vollständige Integration können die Elektroden aufgrund der Begrenzung der Auflösung nicht durch Schattenmasken definiert werden. Für eine Feinstrukturierung eignet sich die Bottom-Kontakt Transistorarchitektur. Bottom-Kontakt Transistoren mit einer OTS-SAM als Gatedielektrikum zeigten jedoch nur Kurzschlüsse zwischen Source/Gate und Drain/Gate.

### Beispiel 2 (T-SAM)

Im Beispiel 2 wird das Verhalten einer Ausführungsform der erfindungsgemäßen Schichtstruktur untersucht.

Im Gegensatz zu Beispiel 1 erlaubt hier ω-Phenoxyoctadecyltrichlorosilan die Herstellung von organischen Feldeffekttransistoren in Top- und Bottom-Kontakt Architektur unabhängig vom organischen Halbleiter. Dieses Verhalten demonstriert die außerordentliche Stabilität und Qualität der T-SAMs.

Für die Darstellung der Top-Kontakt Architektur (siehe Fig. 5b) wurde eine T-SAM aus flüssiger Phase auf ein hoch dotiertes Siliziumsubstrat 21 aufgebracht. Alternativ ist auch ein Aufbringen aus der Gasphase analog Beispiel 1 möglich.

Anschließend wurden der Top-Kontakt Transistor in gleicher Weise fertiggestellt wie in Beispiel 1 beschrieben: Aufdampfen des organischen Halbleiters Pentazen; Definition der Metallkontakte aus Gold- durch Schattenmaske / Verdampfen.

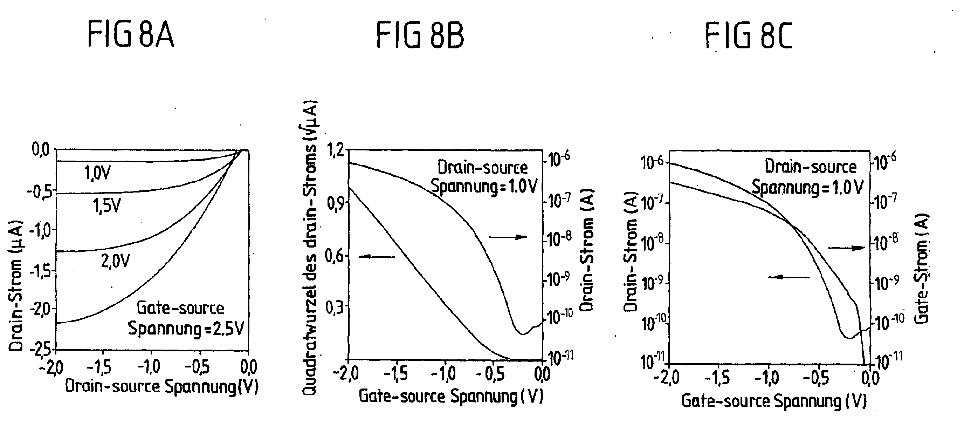

Die Kennlinien eines dermaßen hergestellten organischen Feldeffekttransistors sind in Fig. 8a bis 8c dargestellt (Tabelle 2, Versuch UZ-31). Die Kenndaten sind:
L = 130 µm
W = 170 µm
t_{SAM} = 2,5 nm
ε_{SAM} = 2,5
µ= 0,9 cm²/Vs (Carrier mobility)
Threshold voltage = -0,6 V
Subthreshold slope = 135 mV / decade
on / off current ratio = 10⁴

Die hohe Qualität der T-SAM Schicht der erfindungsgemäßen Schichtstruktur gegenüber der OTS-SAM in zeigt sich hierbei, da bei einem Top-Kontakt Aufbau mit OTS-SAM und Pentazen als Halbleiter kein Feldeffekt beobachtet werden konnte (vgl. Bsp. 1 Punkt a)

Auf T-SAMs lassen sich bei Raumtemperatur Metalle aus der Gasphase abscheiden und photolithografisch strukturieren.

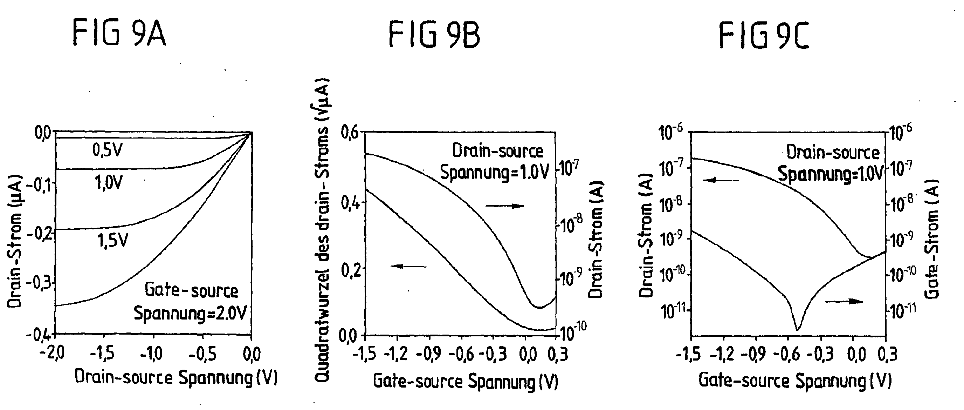

Damit können zu Schaltungen integrierbare organische Feldeffekttransistoren in Bottom-Kontakt Architektur erhalten werden, deren Kennlinien in Fig. 9a bis 9c. abgebildet sind (Tabelle 2, Versuch UZ-33). Kanallänge und Weite sind den jeweiligen Anforderungen anpassbar.

Dazu wird eine T-SAM aus flüssiger Phase auf ein hoch dotiertes Siliziumsubstrat 21 aufgebracht (alternativ ist auch ein Aufbringen aus der Gasphase analog Beispiel 1 möglich). Nachfolgend wird darauf eine 30 nm dicke Goldschicht aufgedampft. Auf dieser werden photolithographisch die Source- und Drainkontakte 23a, 23b definiert und nasschemisch geätzt (I₂/KI-Lösung). Die Kontakte werden mittels Aceton gereinigt, um die Photolack-Ätzmaske zu entfernen. Anschließend wird der organische Halbleiter (Pentazen) abgeschieden.

Transistor Charakteristik UZ-33 (vgl. Tab.2):
L = 5 µm
W = 5 µm
t_{SAM} = 2, 5 nm
ε_{SAM} = 2,5
µ= 0,2 cm²/Vs (Carrier mobility)
Threshold voltage = -0,1 V
Subthreshold slope = 240 mV / decade
on / off current ratio = 10³
drain/gate current ratio = 100.

### Beispiel 3 (T-SAM mit Halbleiter aus flüssiger Phase)

Alternativ zum Aufdampfen der organischen Halbleitern, können auch organische Halbleiter aus der flüssigen Phase aufgebracht werden.

Dazu wird wie in UZ-33 (Beispiel 2, Bottom-Kontakt) verfahren. Anstelle von Pentazen wird eine 1% Lösung von Poly-3-Hexyl-thiophen in Chloroform 10 Sekunden bei 2000 Umdrehungen aufgeschleudert und bei 60°C 10 min auf der Hotplate getrocknet.

### Beispiel 4

Werden an Stelle der ω-substituierten Alkyltrichlorsilane andere geeignete Verbindungen, insbesondere ω-substituierte Alkanthiole und -selenole, wie 18-Phenoxyoctadecanthiol sowie die analogen Disulfide und -selenide eingesetzt, können isolierende SAMs auf Metallen erzeugt werden. Dazu eignen sich Platin, Palladium, Kupfer, Silber, Gold, Quecksilber.
Das Metallsubstrat wird durch Eintauchen in eine ethanolische Lösung der SAM-bildenden Verbindung beschichtet. Die so erhaltene Schichten können durch Aufdampfen von Metallen, oder durch Elektrolyt kontaktiert werden, und zeigen gute Isolationseigenschaften. Die bei 1,5 V gemessene Strom dichte (Gold, 18-Phenoxyoctadecanthiol) beträgt 7,4 A /m².

Weitere Versuche ergaben, dass die Abscheidung aus der Gasphase (verminderter Druck, erhöhte Temperatur) bessere Schichten als eine Deposition aus der Lösung liefert. In Tab. 2 ist dies an den Werten für I_{D}/I_{G} und I_{G} der Versuche MH-357, MH 362 (Gasphase) in Vergleich zu UZ-31, UZ-33 (flüssige Phase) zu erkennen.

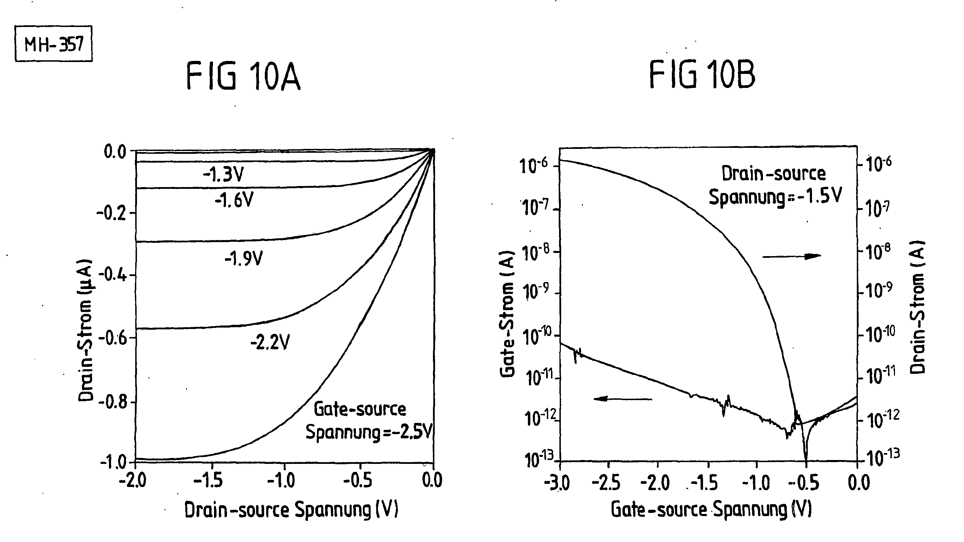

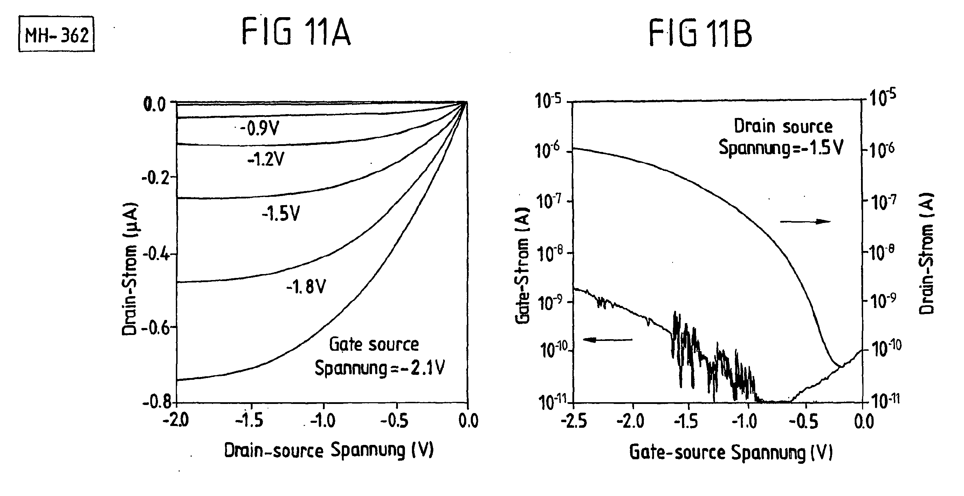

In den Fig. 10A, 10B sind die Kennlinien des Transistors zu der Ausführungsform nach Versuch MH-357 (Top-Kontakt); in den Fig. 11A, 11B sind die Kennlinien des Transistors zu der Ausführungsform nach Versuch MH-362 (Bottom-Kontakt) dargestellt.

Die Erfindung beschränkt sich in ihrer Ausführung nicht auf die vorstehend angegebenen bevorzugten Ausführungsbeispiele. Vielmehr ist eine Anzahl von Varianten denkbar, die von der erfindungsgemäßen Verbindung, der erfindungsgemäßen Schichtstruktur, dem erfindungsgemäßen Halbleiterbauelement und dem erfindungsgemäßen Verfahren wie in den vorliegenden Ansprüchen dargestellt auch bei grundsätzlich anders gearteten Ausführungen Gebrauch machen.

**Tabelle 2**

| Substrat | Gate | SAM | aktive Schicht | Kontakte | Trägermobilität | Schwellenspannung | Unterschwellensteigung | I_{D} an/aus | I_{D}/I_{G} | J_{G} (V_{GS}=-1V) |
|---|---|---|---|---|---|---|---|---|---|---|
| UZ-31 | Si | PhO | Pentacen | oben | 0,9 cm²/V-s | -0,6 V | 135 mV/dec | 10⁴ | 2,8 | 7x10⁻⁵A/cm² |
| UZ-33 | Si | PhO | Pentacen | unten | 0,2 cm²/V-s | -0,1 V | 240 mV/dec | 10³ | 10² | |
| UZ-35 | Si | OTS | Dec-6T-Dec | oben | 0,04 cm²/V-s | 0 V | 200 mV/dec | 10³ | 10² | 2x10⁻⁷ A/cm² |
| UZ-36 | Si | OTS | Pentacen | oben | no FE | | | | | 5x10⁻³ A/cm² |
| UZ-37 | Si | | Dec-6T-Dec | oben | no FE | | | | | 2x10⁻³ A/cm² |
| UZ-43 | Al | OTS | Dec-6T-Dec | oben | 0,03 cm²/V-s | -0,9 V | 360 mV/dec | 10³ | 5,3 | 2x10⁻⁸ A/cm² |
| MH-357 | Si | PhO | Pentacen | oben | 1 cm²/V-s | -1,3 V | 100 mV/dec | 10⁶ | 10⁴ | 2x10⁻⁹ A/cm⁹ |
| MH-362 | Si | PhO | Pentacen | unten | 0,05 cm²/V-s | -0,7 V | 140 mV/dec | 10⁴ | 10³ | 3x10⁻⁸ A/cm² |

**Tabelle 1**

| **Technologie Parameter** | **T-SAM Transistor** | **170 nm ITRS Knoten** |
|---|---|---|
| | | TFTs |
| Dielektrische Dicke | 2,5 | 2,5 |
| Kanallänge, µm | 5 | 0,12 |
| Trägermobilität, cm²/V-s | > 1 | < 500 |
| Betriebsspannung, V | 1,5 | 1,8 |
| Schwellenspannung, V | -0,1 | ∼0,3 |
| Unterschwellen-Swing, mV/dec | 135 | 70 |
| Gate-Fehlerstrom, nA/µm | < 0,05 | 7 |
| On-state Drain-Strom, µA/µm | > 0,02 | 750 |
| An/Aus-Stromverhältnis | > 10⁴ | 10⁵ |

### Bezugszeichenliste

- 1: Ankergruppe
- 2: dielektrische Gruppe
- 3: Gruppe mit einer π-π Wechselwirkung (Kopfgruppe)
- 5: Verbindung zur Bildung einer selbstorganisierenden Schicht

- 10: Substrat
- 11: Monolage aus Molekülen

- 20: Basis-Substrat für OFET
- 21: Gateelektrode
- 22: Gatedielektrikumsschicht
- 23a: Sourceschicht
- 23b: Drainschicht
- 24: aktive Halbleiterschicht
- 25: Passivierungsschicht

- 100: Halbleiterbauelement (organischer Feldeffekttransistor)

## Patentansprüche

1. Halbleiterbauelement
**gekennzeichnet durch**
die Schichtabfolge Basissubstrat (20), Gateelektrode (21) und Gatedielektrikumsschicht (22), wobei auf der Gatedielektrikumsschicht (22) eine Source-Elektrode (23a), eine Drain-Elektrode (23b) und / oder eine halbleitende Schicht (24) angeordnet sind,
wobei die halbleitende Schicht (24) auf die Gatedielektrikumsschicht (22) abgeschieden wird,
und wobei die Gatedielektrikumsschicht (22) eine Monolage (11) aus Verbindungen (5) der Struktur ω-Phenoxyoctadecyltrichlorsilan umfasst.

2. Halbleiterbauelement nach Anspruch 1, **dadurch gekennzeichnet, dass** die Monolage (11) auf ein Substrat (10) mit einer metallischen Oberfläche, einer metalloxidischen Oberfläche und / oder einer Kunststoffoberfläche angeordnet ist.

3. Halbleiterbauelement nach Anspruch 2, **dadurch gekennzeichnet, dass** das Substrat (10) eine hydroxylgruppenhaltige Oberfläche aufweist.

4. Halbleiterbauelement nach Anspruch 3, **dadurch gekennzeichnet, dass** das Substrat (10) Silizium oder Aluminium ist.

5. Halbleiterbauelement nach mindestens einem der vorhergehenden Ansprüche, **dadurch gekennzeichnet, dass**
a) die Monolage (11) mittels Trichlorsilan als Ankergruppe (1) mit dem Substrat (10) verbunden ist,
b) vom Substrat (10) aus gesehen oberhalb der Ankergruppe (1) eine Schicht aus Octadecyl als dielektrischen Gruppe (2) und
c) oberhalb der dielektrischen Gruppe (2) eine Schicht aus Phenyl als molekularer Gruppe mit der Fähigkeit einer n-n Wechselwirkung (3) angeordnet ist.

6. Verfahren zur Herstellung eines Halbleiterbauelementes nach mindesten einem der vorhergehenden Ansprüche, **dadurch gekennzeichnet, dass** die Monolage (11) aus einer flüssigen Phase oder einer Gasphase auf ein Substrat abgeschieden wird.

7. Verfahren nach Anspruch 6, **dadurch gekennzeichnet, dass** die Monolage (11) aus einer flüssigen Phase mit einem organischen Lösungsmittel in einem Tauchprozess abgeschieden wird.

## Claims

1. Semiconductor component,
**characterized by**
the layer sequence base substrate (20), gate electrode (21) and gate dielectric layer (22), a source electrode (23a), a drain electrode (23b) and/or a semiconducting layer (24) being arranged on the gate dielectric layer (22),
the semiconducting layer (24) being deposited on the gate dielectric layer (22),
and the gate dielectric layer (22) comprising a monolayer (11) of compounds (5) having the structure ω-phenoxyoctadecyltrichlorosilane.

2. Semiconductor component according to Claim 1, **characterized in that** the monolayer (11) is arranged on a substrate (10) having a metallic surface, a metal oxide surface and/or a plastics surface.

3. Semiconductor component according to Claim 2, **characterized in that** the substrate (10) has a surface containing hydroxyl groups.

4. Semiconductor component according to Claim 3, **characterized in that** the substrate (10) is silicon or aluminium.

5. Semiconductor component according to at least one of the preceding claims, **characterized in that**
a) the monolayer (11) is connected to the substrate (10) by means of trichlorosilane as anchor group (1),
b) viewed from the substrate (10), a layer of octadecyl as dielectric group (2) is arranged above the anchor group (1) and
c) a layer of phenyl as a molecular group having the ability to undergo a π-π interaction (3) is arranged above the dielectric group (2).

6. Process for the production of a semiconductor component according to at least one of the preceding claims, **characterized in that** the monolayer (11) is deposited onto a substrate from a liquid phase or a gas phase.

7. Process according to Claim 6, **characterized in that** the monolayer (11) is deposited from a liquid phase with an organic solvent in an immersion process.

## Revendications

1. Composant semi-conducteur,
**caractérisé par**
une succession de couches constituée du substrat de base (20), de l'électrode de grille (21) et d'une couche diélectrique de grille (22), d'une électrode de source (23a), d'une électrode de drain (23b) et/ou d'une couche semi-conductrice (24) ét ant disposée(s) sur la couche diélectrique de grille (22),
la couche semi-conductrice (24) étant déposée sur la couche diélectrique de grille (22),
la couche diélectrique de grille (22) comprenant une monocouche (11) constituée de composés (5) qui présentent la structure ω-phénoxyoctadécyltrichlorosilane.

2. Composant semi-conducteur selon la revendication 1, **caractérisé en ce que** la monocouche (11) est disposée sur un substrat (10) qui présente une surface métallique, une surface d'oxyde métallique et/ou une surface de matière synthétique.

3. Composant semi-conducteur selon la revendication 2, **caractérisé en ce que** le substrat (10) présente une surface qui contient des groupes hydroxyle.

4. Composant semi-conducteur selon la revendication 3, **caractérisé en ce que** le substrat (10) est en silicium ou en aluminium.

5. Composant semi-conducteur selon au moins l'une des revendications précédentes, **caractérisé en ce que**
a) la monocouche (11) est reliée au substrat (10) au moyen de trichlorosilane qui sert de groupe d'ancrage (1),
b) vue du substrat (10), une couche d'octadécyle qui sert de groupe diélectrique (2) est disposée au-dessus du groupe d'ancrage (1) et
c) une couche de phényle qui sert de groupe moléculaire doté d'une capacité d'interaction π-π (3) est disposée au-dessus du groupe diélectrique (2).

6. Procédé de fabrication d'un composant semi-conducteur selon au moins l'une des revendications précédentes, **caractérisé en ce que** la monocouche (11) est déposée en phase liquide ou en phase gazeuse sur un substrat.

7. Procédé selon la revendication 6, **caractérisé en ce que** la monocouche (11) est déposée en phase liquide à l'aide d'un solvant organique, par une opération d'immersion.
